# EUROPÄISCHE PATENTSCHRIFT

(11) **EP 0 526 466 B1**
(45) Veröffentlichungstag und Bekanntmachung des Hinweises auf die Patenterteilung: **14.09.1994**
(21) Anmeldenummer: 91905807.3
(22) Anmeldetag: 23.03.1991
(51) Int. Cl.: H05K 5/00

(54) **ELEKTRISCHES SCHALT- UND STEUERGERÄT, INSBESONDERE FÜR KRAFTFAHRZEUGE**
ELECTRIC SWITCHING AND CONTROL DEVICE, IN PARTICULAR FOR MOTOR VEHICLES
DISPOSITIF ELECTRIQUE DE COMMUTATION ET DE COMMANDE, EN PARTICULIER POUR VEHICULES AUTOMOBILES

(30) Priorität: 14.04.1990 DE 4012182
(43) Veröffentlichungstag der Anmeldung: 10.02.1993
(73) Patentinhaber: ROBERT BOSCH GMBH, 70442 Stuttgart (DE)
(72) Erfinder: KLINGER, Herbert, D-8500 Nürnberg 60 (DE); THOMAS, Gerhard, D-8510 Fürth (DE); PETRZIK, Martin, D-8500 Nürnberg 90 (DE)
(86) Internationale Anmeldenummer: DE9100261
(87) Internationale Veröffentlichungsnummer: WO9116807

(56) Entgegenhaltungen:
- DE-A- 2 530 157
- DE-A- 3 502 584
- DE-A- 3 712 235
- GB-A- 2 045 009

## Beschreibung

### Stand der Technik

Die Erfindung geht aus von einem elektrischen Schalt- und Steuergerät, vorzugsweise für Kraftfahrzeuge, nach dem Oberbegriff des Patentanspruchs 1.

Aus der WO 78/01007 ist ein elektrisches Schaltgerät bekannt, bei dem Leistungsbauelemente mit einem Kühlkörper wärmeleitend und elektrisch isoliert verbunden sind, wobei die Anschlüsse der Leistungsbauelemente mit einer Leiterplatte kontaktiert sind, die wiederum mit einer Steckerleiste an der Frontseite des Schaltgerätes kontaktiert ist. Der Kühlkörper ist dort auf der Leiterplatte festgeschraubt, wobei die von ihm aufgenommene Wärme von den Leistungsbauelementen wärmeleitend und elektrisch isoliert über die Frontplatte oder vom Gehäuse nach außen abgeführt wird. Darüber hinaus ist es aus der DE-A 33 10 477 bekannt, für einen feuchtigkeitsdichten Abschluß des Gehäuses die Steckerleiste mit einem Dichtring an einer Frontplatte des Gehäuses festzuschrauben und diese dann über einen weiteren Dichtring auf der frontseitigen Gehäuseöffnung des Schalt- und Steuergerätes zu befestigen.

Schließlich ist es aus der DE-A- 37 12 235 bekannt, bei einem elektrischen Steuergerät nach dem Oberbegriff des Anspruchs 1 für die Leistungsbauelemente auf beiden Schmalseiten im Gehäuseinneren je einen Kühlkörper anzuordnen, der einerseits mit einer Leiterplatte und andererseits mit der die Steckerleiste aufnehmenden Frontplatte verschraubt bzw. vernietet ist. Dabei sind die inneren Enden der Steckerzungen an der Steckerleiste mit Leiterbahnen der Leiterplatte verlötet.

Derartige Lösungen haben den Nachteil, daß durch die Fertigungs- und Montagetoleranzen die Lötverbindungen der Steckerzungen mit den Leiterbahnen der Leiterplatte nach dem Lötvorgang während und nach der Fertigmontage mechanisch belastet werden. Außerdem ist dort die Länge des Kühlkörpers durch die Breite der Steckerleiste vorgegeben, so daß nur eine begrenzte Anzahl von Leistungsbauelementen in dem Schalt- und Steuergerät untergebracht werden können. Für weitere Leistungsbauelemente müssen weitere Kühlkörper bzw. Kühlbleche im Bereich des Gehäusebodens oder der Seitenwände angeordnet und mit der Leiterplatte einzeln verschraubt bzw. vernietet werden, dabei treten ebenfalls Toleranzprobleme auf.

Mit der vorliegenden Lösung wird angestrebt, einen Kühlkörper so auszubilden, daß einerseits eine Vielzahl von elektrischen Leistungsbauelementen mit ihm wärmeleitend zu verbinden ist und der andererseits eine einfache Montage der Leiterplatte mit der Steckerleiste an der Frontplatte zuläßt, bei der die Lötstellen der Steckerteile an der Leiterplatte mechanisch nach dem Lötvorgang unbelastet bleiben.

### Vorteile der Erfindung

Das erfindungsgemäße Schalt- und Steuergerät mit den kennzeichnenden Merkmalen des Patentanspruchs 1 hat den Vorteil, daß durch die feuchtigkeitsdichte Anbringung der Frontplatte am Kühlkörper auf kostengüstige, einfache Weise die Lötstellen der Steckerteile an der Leiterplatte mechanisch entlastet werden und daß auch bei einer Vielzahl von elektronischen Leistungsbauelementen die von ihnen abgegebene Wärme rasch vom Kühlkörper aufgenommen und über die Frontplatte nach außen abgegeben werden kann. Als weiterer Vorteil ist anzusehen, daß durch die mögliche, relativ große Masse des Kühlkörpers die Wärme von allen Leistungsbauelementen unabhängig von deren Platzierung gleich gut aufgenommen werden kann.

Durch die in den Unteransprüchen aufgeführten Maßnahmen ergeben sich vorteilhafte Weiterbildungen und Verbesserungen der im Patentanspruch 1 angegebenen Merkmale. Bei einem Schalt- und Steuergerät mit mehreren Leistungsbauelementen ist es besonders zweckmäßig, wenn der Kühlkörper an gegenüberliegenden Seiten seines die Steckerleiste einfassenden Rahmens jeweils einen nach hinten abgewinkelten, oder parallel zur Steckerleiste plattenförmigen Abschnitt aufweist, an den die Leistungsbauelemente wärmeleitend angebracht sind. Eine zweckmäßige Aufnahme und feste Fixierung der Steckerleiste vor dem Löten im Rahmen des Kühlkörpers wird dadurch erreicht, daß die Steckerleiste außen an ihren Schmalseiten je eine Nut aufweist, in die jeweils eine Leiste des Kühlkörper-Rahmens eingreift. Damit ergibt sich eine einfache Steck-Montage und ferner eine vorteilhafte Möglichkeit zum Ausgleich von Fertigungs- und Montagetoleranzen, in dem die Nutbreite an der Steckerleiste größer als die Leistendicke am Kühlkörper-Rahmen gewählt ist und daß in jeder Nut eine Pressnase zum Toleranzausgleich angeformt ist.

### Zeichnung

Ein Ausführungsbeispiel der Erfindung ist in der Zeichnung dargestellt und in der nachfolgenden Beschreibung-näher erläutert. Es zeigen Figur 1 die Einzelteile des Schalt- und Steuergerätes vor dem Zusammenbau, in raumbildlicher Darstellung, Figur 2 die Anbringung eines Leistungsbauelementes am Kühlkörper und Figur 3 die vormontierte Baueinheit aus Kühlkörper, Leiterplatte und Leistungsbauelementen vor der Verlötung.

### Beschreibung des Ausführungsbeispiels

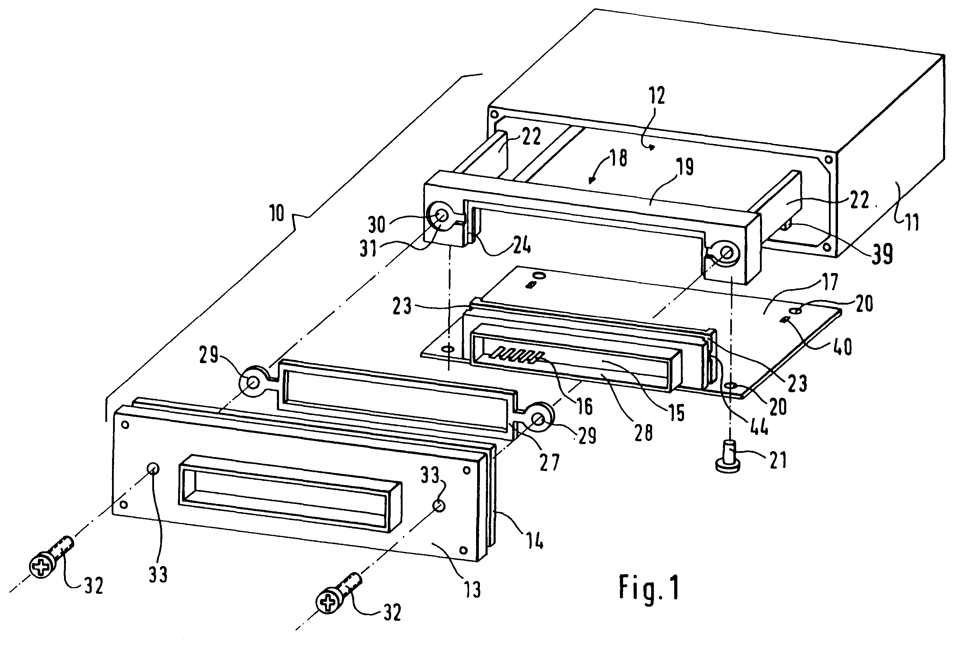

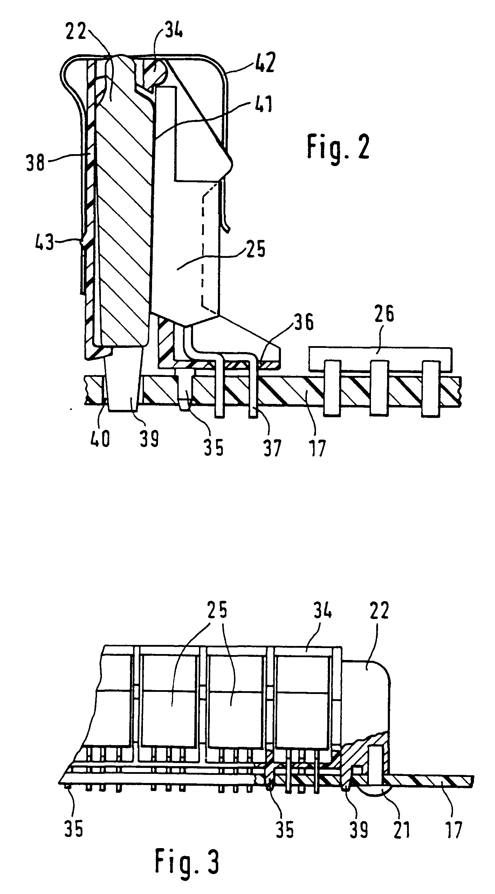

Figur 1 zeigt in raumbildlicher Darstellung die Einzelteile eines erfindungsgemäßen Schalt- und Steuergerätes 10 für ein Kraftfahrzeug. Es besteht aus einem Isolierstoffgehäuse oder Alu-Gehäuse 11 mit einer vorn offenen Stirnseite 12, die von einer Frontplatte 13 aus Aluminium mittels eines Dichtrings 14 und vier nicht dargestellten Schrauben feuchtigkeitsdicht verschließbar ist. Zur Herstellung des Gerätes 10 wird zunächst eine vorgefertigte Steckerleiste 15 mit in Kunststoff eingebetteten Steckerzungen 16 auf das stirnseitige Ende einer Leiterplatte 17 aufgesetzt, in dem die Steckerzungen 16 mit ihren hinteren, nach unten abgewinkelten Enden durch entsprechende, nicht erkennbare Löcher in der Leiterplatte 17 hindurchragen. Die Steckerleiste 15 kann dabei durch an ihr angeformte Rastmittel mit der Leiterplatte 17 an der vorgesehenen Position verrastet werden. Danach wird ein Kühlkörper 18 aus Aluminium-Druckguß auf die Leiterplatte 17 aufgesetzt, wobei der Kühlkörper 18 mit einem Rahmen 19 die Steckerleiste 15 einfaßt. Der Rühlkörper 18 ist an den gegenüberliegenden Seiten seines Rahmens 19 jeweils mit einem nach hinten abgewinkelten, plattenförmigen Abschnitt 22 versehen, auf den - wie zu Figur 3 näher erläutert - Leistungsbauelemente des Gerätes 10 wärmeleitend angebracht werden. Zur Aufnahme der Steckerleiste 15 am Rahmen 19 des Kühlkörpers 18 ist diese außen an ihren Schmalseiten mit jeweils einer Nut 23 versehen, in die jeweils eine Leiste 24 des Kühlkörper-Rahmens 19 eingreift. Zum Ausgleich von Fertigungs- und Montagetoleranzen ist die Nutbreite an der Steckerleiste 15 größer gewählt als die Leistendicke am Kühlkörper-Rahmen 19. Der Kühlkörper 18 wird mit der Leiterplatte 17 vernietet, in dem gemäß Figur 3 Niete 21 durch entsprechende Bohrungen 20 der Leiterplatte hindurch in Sacklöcher des Kühlkörpers 18 eingenietet werden. Die Toleranzen zwischen den Nuten 23 an den Schmalseiten der Steckerleiste 15 und der Leiste 24 des Kühlkörper-Rahmens 19 kann durch an der Steckerleiste 15 angespritzte, verformbare bzw. abreibbare Preßnasen 44 eliminiert werden.

Die so vorgefertigte Baueinheit kann nun gemäß Figur 2 und 3 mit elektronischen Leistungsbauelementen 25 sowie weiteren elektronischen Komponenten 26 bestückt werden, die dann gemeinsam mit den Steckerzungen 16 mit Leiterbahnen der Leiterplatte 17 verlötet und geprüft werden. Zwischen Leiterplatte und Steckerleiste besteht durch den Kühlrahmen ein fester Verbund, dadurch können die Lötstellen der Pins der Steckerleiste auf der Leiterplatte nicht mehr mechanisch belastet werden. Zwischen der Steckerleiste 15 und der Frontplatte 13 wird eine Dichtung 27 eingesetzt, die einen Kragen 28 der Steckerleiste 15 ringförmig einfaßt und an den Schmalseiten jeweils ein angeformtes Dichtauge 29 aufweist. Der Kühlkörper-Rahmen 19 hat jeweils zu beiden Seiten der Steckerleiste 15 eine Gewindebohrung 30 oder eine Bohrung für eine Gewindefurch-Schraube sowie eine Ausnehmung 31, in die jeweils ein Dichtauge 29 der Dichtung 27 eingelegt wird. Zwei Schrauben 32 werden durch je ein Loch 33 der Frontplatte 13 und ein Dichtauge 29 der Dichtung 27 hindurch in die Gewindebohrungen 30 des Kühlkörper-Rahmens 19 eingeschraubt. Die Steckerleiste 15 ist damit feuchtigkeitsdicht von der Frontplatte 13 abgedeckt, so daß nunmehr auf diese vormontierte Baugruppe das Gehäuse 11 aufgeschoben und mit der Frontplatte 13 feuchtigkeitsdicht verschraubt werden kann.

Figur 2 und 3 zeigen, daß die Leistungsbauelemente 25 in einem Kunststoffrahmen 34 eingesetzt sind, der mit Führungsansätzen 35 in entsprechende Löcher der Leiterplatte 17 positioniert ist. Durch konisch erweiterte Löcher 36 des Kunststoffrahmens 34 können beim Einsetzen der Leistungsbauelemente 25, deren Anschlußpins 37 in darunter liegende Löcher der Leiterplatte 17 eingefädelt werden. Für jede der plattenförmige Abschnitte 22 des Kühlkörpers 18 ist ein Kunststoffrahmen 34 vorgesehen, der mit rückseitig angeformten Zungen 38 auf den plattenförmigen Abschnitt 22 des Kühlkörpers 18 aufgeschoben und mit ihm verrastet ist. Außerdem ragen Führungszapfen 39 der plattenförmigen Abschnitte 22 des Kühlkörpers 18 in entsprechende Durchbrüche 40 der Leiterplatte. Zwischen der Vorderseite der plattenförmigen Abschnitte 22 des Kühlkörpers 18 und den elektronischen Leistungsbauelementen 25 ist eine elektrisch isolierende, wärmeleitende Folie 41 am Kühlkörper 18 aufgeklebt. Anstelle einer Schraubbefestigung werden hier die Leistungsbauelemente 25 mit samt ihrem Kunststoffrahmen 34 durch Klemmfedern 42 am plattenförmigen Abschnitt 22 des Kühlkörpers 18 festgeklemmt. Durch je eine Nase 43 an der Rückseite der Zunge 38 des Kunststoffrahmens 34 werden die Klemmfedern 42 jeweils gehalten.

## Patentansprüche

1. Elektrisches Schalt- und Steuergerät (10), insbesondere für Kraftfahrzeuge, mit in einem Gehäuse (11) angeordneten elektronischen Leistungsbauelementen (25), deren Anschlüsse (37) mit einer weitere Bauelemente (26) tragenden und damit verschalteten Leiterplatte (17) verlötet sind, mit einem die Leistungsbauelemente (25) tragenden Kühlkörper (18), der mit der Leiterplatte (17) mechanisch verbunden ist und der die in den Leistungsbauelementen (25) erzeugte Wärme aufnimmt und nach außen abführt sowie mit einer Steckerleiste (15) an der Frontseite des Gehäuses (11), deren Steckerteile (16) an ihren hinteren Enden mit der Leiterplatte (17) verlötet sind, wobei eine Frontplatte (13) unter Zwischenfügung einer Dichtung (27) auf einem Kragen (28) der Steckerleiste (15) aufgesetzt und mit dem Kühlkörper (18) fest verschraubt ist sowie mit einem Dichtring (14) die stirnseitige Gehäuseöffnung (12) dicht verschließt, dadurch gekennzeichnet, daß die Steckerleiste (15) an der Leiterplatte (17) verrastbar ist und der mit der Leiterplatte (17) fest verbundene Kühlkörper (18) mit einem Rahmen (19) die Steckerleiste (15) einfaßt.

2. Schalt- und Steuergerät nach Anspruch 1, dadurch gekennzeichnet, daß der Kühlkörper (18) an gegenüberliegenden Seiten seines die Steckerleiste (15) einfassenden Rahmens (19) jeweils einen nach hinten abgewinkelten, plattenförmigen Abschnitt (22) aufweist, auf dem Leistungsbauelemente (25) wärmeleitend befestigt sind.

3. Schalt- und Steuergerät nach Anspruch 1 oder 2, dadurch gekennzeichnet, daß die Steckerleiste (15) außen an ihren Schmalseiten je eine Nut (23) aufweist, in die jeweils eine Leiste (24) des Kühlkörper-Rahmens (19) eingreift.

4. Schalt- und Steuergerät nach Anspruch 3, dadurch gekennzeichnet, daß die Nutbreite an der Steckerleiste (15) größer als die Leistendicke am Kühlkörper-Rahmen (19) ist und in der Nut (23) Preßnasen (44) zum Toleranzausgleich vorgesehen sind.

5. Schalt- und Steuergerät nach einem der vorhergehenden Ansprüche, dadurch gekennzeichnet, daß die zwischen Steckerleiste (15) und Frontplatte (13) eingesetzte Dichtung (27) den Kragen (28) der Steckerleiste (15) ringförmig einfaßt und an den Schmalseiten mit je einem angeformten Dichtauge (29) in eine entsprechende Ausnehmung (31) des Kühlkörper-Rahmens (19) eingelegt ist, wobei jeweils eine Schraube (32) durch ein entsprechendes Loch (33) der Frontplatte (13) und dem dahinter liegenden Dichtauge (29) hindurch in eine Gewindebohrung (30) des Kühlkörper-Rahmens (19) eingeschraubt ist.

6. Schalt- und Steuergerät nach Anspruch 2, dadurch gekennzeichnet, daß die Leistungsbauelemente (25) in einem Kunststoffrahmen (34) eingesetzt sind, der mit Führungsansätzen (35) in entsprechende Löcher der Leiterplatte (17) so positioniert ist, daß die Anschlußpins (37) der Leistungsbauelemente (25) durch konisch erweiterte Löcher (36) des Kunststoffrahmens (34) in die ihnen zugeordneten Löcher der Leiterplatte (17) einzufädeln sind.

7. Schalt- und Steuergerät nach Anspruch 6, dadurch gekennzeichnet, daß der Kunststoffrahmen (34) der Leistungsbauelemente (25) mit dem plattenförmigen Abschnitt (22) des Kühlkörpers (18) verrastbar ist.

8. Schalt- und Steuergerät nach Anspruch 7, dadurch gekennzeichnet, daß die Leistungsbauelemente (25) mit ihrem Kunststoffrahmen (34) durch Klemmfedern (42) am plattenförmigen Abschnitt (22) des Kühlkörpers (18) befestigt sind.

9. Schalt- und Steuergerät nach Anspruch 2, dadurch gekennzeichnet, daß die plattenförmigen Abschnitte (22) des Kühlkörpers (18) an der Unterseite Führungszapfen (39) zur Aufnahme entsprechender Durchbrüche (40) der Leiterplatte (17) aufweisen.

## Claims

1. Electric switching and control device (10), in particular for motor vehicles, comprising electronic power components (25) which are arranged in a housing (11) and whose terminals (37) are soldered to a printed circuit board (17) which bears further components (26) and is connected thereto, having a cooling element (18) which bears the power components (25) and is mechanically connected to the printed circuit board (17) and receives the heat which is produced in the power components (25) and conducts it away to the outside, and having a connector strip (15) on the front of the housing (11) whose plug components (16) are soldered at their rear ends to the printed circuit board (17), a front panel (13) being fitted onto a collar (28) of the connector strip (15) with the intermediate connection of a seal (27) and is permanently screwed to the cooling element (18), and seals off the end-side housing opening (12) in a tight fashion with a sealing ring (14), characterized in that the connector strip (15) can be locked to the printed circuit board (17) and the cooling element (18) which is permanently connected to the printed circuit board (17) holds the connector strip (15) with a frame (19).

2. Switching and control device according to Claim 1, characterized in that the cooling element (18) has on opposite sides of its frame (19) which holds the connector strip (15) in each case a plate-shaped section (22) which is bent at the rear and on which power components (25) are attached in a heat-conducting fashion.

3. Switching and control device according to Claim 1 or 2, characterized in that the connector strip (15) has on the outside on its narrow sides in each case one groove (23) into which in each case one strip (24) of the cooling element frame (19) engages.

4. Switching and control device according to Claim 3, characterized in that the width of the groove at the connector strip (15) is greater than the thickness of the strip at the cooling element frame (19) and press-in projections (44) for tolerance compensation are provided in the groove (23).

5. Switching and control device according to one of the preceding claims, characterized in that the seal (27) which is inserted between connector strip (15) and front panel (13) encloses the collar (28) of the connector strip (15) in an annular fashion and, at the narrow sides, is inserted with in each case one formed-on sealing eyelet (29) into a corresponding recess (31) of the cooling element frame (19), in each case one screw (32) being screwed into a threaded hole (30) of the cooling element frame (19) through a corresponding hole (33) in the front panel (13) and the sealing eyelet (29) located behind it.

6. Switching and control device according to Claim 2, characterized in that the power components (25) are inserted in a plastic frame (34) which is positioned with guide shoulders (35) in the corresponding holes of the printed circuit board (17) such that the connection pins (37) of the power components (25) can be fitted through conically widened holes (36) of the plastic frame (34) into the holes, assigned to them, of the printed circuit board (17).

7. Switching and control device according to Claim 6, characterized in that the plastic frame (34) of the power components (25) can be locked to the plate-shaped section (22) of the cooling element (18).

8. Switching and control device according to Claim 7, characterized in that the power components (25) are attached to their plastic frame (34) by clamping springs (42) on the plate-shaped section (22) of the cooling element (18).

9. Switching and control device according to Claim 2, characterized in that the plate-shaped sections (22) of the cooling element (18) have on the underside guide pins (39) for receiving corresponding openings (40) in the printed circuit board (17).

## Revendications

1. Appareil électrique de commutation et de commande (10), en particulier pour véhicules à moteur, avec des composants électroniques de puissance (25), disposés dans un boîtier (11), dont les raccords (37) sont brasés sur une carte de circuit imprimé (17) portant d'autres composants (26) et branchés de cette façon à un corps de refroidissement (18) portant les composants de puissance (25), corps qui est relié mécaniquement à la carte de circuit imprimé (17) et qui recueille la chaleur dégagée dans les composants de puissance (25) pour l'évacuer vers l'extérieur, ainsi qu'à une borne de connexion (15) sur le côté frontal du boîtier (11), borne dont les pièces d'enfichage (16) sont brasées à leurs extrémités arrière sur la carte de circuit imprimé (17), une plaque frontale (13) étant mise sur une collerette de la borne de connexion (15) avec interposition d'un joint d'étanchéité (27) et étant fixée solidairement avec le corps de refroidissement (18) ainsi qu'avec une bague d'étanchéité (14) qui ferme de façon étanche l'ouverture du boîtier (12) du côté frontal, appareil électrique de commutation et de commande selon la revendication 1, caractérisé en ce que la borne de connexion (15) peut être encliquetée sur la carte de circuit imprimé (17) et en ce que le corps de refroidissement (18) relié de façon solidaire à la carte de circuit imprimé (17) entoure par un cadre (19) la borne de connexion (15).

2. Appareil électrique de commutation et de commande selon la revendication 1, caractérisé en ce que le corps de refroidissement (18) présente sur les côtés opposés de son cadre (19) enfermant la borne de connexion (15) respectivement une section (22) repliée à l'arrière, en forme de plaque, sur laquelle les composants de puissance (25) sont fixés d'une manière conduisant la chaleur.

3. Appareil de commutation et de commande selon la revendication 1 ou 2, caractérisé en ce que la borne de connexion (15) présente à l'extérieur, sur ses côtés étroits, respectivement une rainure (23) dans laquelle vient respectivement en prise une nervure (24) du cadre du corps de refroidissement (19).

4. Appareil de commutation et de commande selon la revendication 3, caractérisé en ce que la largeur de la rainure sur la borne de connexion (15) est plus grande que l'épaisseur de la nervure sur le cadre du corps de refroidissement (19) et en ce que dans la rainure (23), sont prévus des nez de pression (44) pour compenser les jeux.

5. Appareil de commutation et de commande selon l'une des revendications précédentes, caractérisé en ce que le joint d'étanchéité (27) inséré entre la borne de connexion (15) et la plaque frontale (13) entoure en forme d'anneau la collerette (28) de la borne de connexion (15) et en ce qu'il est placé sur les côtés étroits avec respectivement un oeillet d'étanchéité (29) rattaché dans un évidement correspondant (31) du cadre du corps de refroidissement (19), une vis (32) étant vissée respectivement à travers un trou correspondant (23) de la plaque frontale (13) et l'oeillet d'étanchéité (29) qui se trouve en arrière, dans un perçage fileté (30) du cadre du corps de refroidissement (19).

6. Appareil de commutation et de commande selon la revendication 2, caractérisé en ce que les composants de puissance (25) sont insérés dans un cadre en matière plastique (34) qui est positionné par des appendices de guidage (35) dans des trous correspondants de la carte de circuit imprimé (17), de telle façon que les pointes de raccordement (37) des composants de puissance (25) puissent être enfilées à travers des trous (36) évasés de façon conique, du cadre en matière plastique (34), dans leurs trous correspondants de la carte de circuit imprimé (17).

7. Appareil de commutation et de commande selon la revendication 6, caractérisé en ce que le cadre en matière plastique (34) des composants de puissance (25) peut être encliqueté avec la section en forme de plaque (22) du corps de refroidissement (18).

8. Appareil de commutation et de commande selon la revendication 7, caractérisé en ce que les composants de puissance (25) sont fixés par leur cadre en matière plastique (34), par des ressorts d'agrafage (42), sur la section en forme de plaque (22) du corps de refroidissement (18).

9. Appareil de commutation et de commande selon la revendication 2, caractérisé en ce que les sections en forme de plaque (22) du corps de refroidissement (18) présentent, sur la face inférieure, des tenons de guidage (39) servant à recevoir des évidements correspondants (40) de la carte de circuit imprimé (17).
